# EUROPÄISCHE PATENTSCHRIFT

(11) **EP 1 475 875 B1**
(45) Veröffentlichungstag und Bekanntmachung des Hinweises auf die Patenterteilung: **15.07.2020**
(21) Anmeldenummer: 04101298.0
(22) Anmeldetag: 30.03.2004
(51) Int. Cl.: H02H 7/08, G01R 31/40

(54) **Verfahren und Anordnung zur Prüfung einer Leistungsendstufe**
Method and device to monitor a power output stage
Méthode et dispositif pour vérifier un étage de puissance

(30) Priorität: 09.05.2003 DE 10320926
(43) Veröffentlichungstag der Anmeldung: 10.11.2004
(73) Patentinhaber: Continental Automotive GmbH, 30165 Hannover (DE)
(72) Erfinder: Bay, Wolfgang, 65936, Frankfurt am Main (DE); Fischer, Patrick, 63454, Hanau (DE); Henninger, Michael, 65779, Kelkheim (DE)

(56) Entgegenhaltungen:
- WO-A1-97/32220
- GB-A- 2 323 223
- JP-A- 59 075 167
- US-A- 4 459 693

## Beschreibung

Die Erfindung betrifft ein Verfahren und eine Anordnung zur Prüfung einer Leistungsendstufe gemäß dem Oberbegriff von Anspruch 1 und 5, wobei die Leistungsendstufe mindestens eine aus einer Reihenschaltung eines oberen und eines unteren Halbleiterschalters bestehende und mit Betriebsspannung beaufschlagte Halbbrücke aufweist und wobei der Verbindungspunkt der Halbleiterschalter der mindestens einen Halbbrücke einen Ausgang bildet.

Mit Halbleiterschaltern bestückte Leistungsendstufen werden unter anderem in Kraftfahrzeugen zur Ansteuerung von Verbrauchern, beispielsweise Gleichstrommotoren, verwendet. Durch die rasante Entwicklung von niederohmigen Leistungs-MOSFETs können auch Verbraucher im Kilowattbereich kostengünstig angesteuert werden. In Kraftfahrzeugen kann es vorkommen, dass die Leistungsendstufe und der Verbraucher räumlich voneinander getrennt angeordnet werden, wobei Kurzschlüsse der Verbraucherzuleitungen gegen Masse oder gegen Batteriespannung zu hohen Fehlerströmen führen können. Schmelzsicherungen können im Allgemeinen in diesen Stromkreisen aufgrund ihrer Toleranzen, ihrer Innenwiderstände und der hohen Nutzströme nicht eingesetzt werden. Außerdem kann infolge eines defekten MOSFETs in der Leistungsendstufe ein hoher Fehlerstrom fließen.

Aus der GB 2 323 223 A ist eine Anordnung zur Umwandlung von Gleichstrom zu Wechselstrom bekannt, bei der ein erstes Halbleiterschaltelement in einem oberen Arm und ein zweites Halbleiterschaltelement in einem unteren Arm mit der Gleichspannungsversorgung verbunden ist. Ein erster Komparator vergleicht eine Ausgangsspannung der Schaltung mit einer positiven Eingangsspannung und ein zweiter Komparator mit einer negativen Eingangsspannung. Basierend auf den Ergebnissen der Vergleiche wird ein mögliches abnormales Verhalten detektiert. Eine Überprüfung bei nicht leitenden Halbleiterschaltern wird nicht durchgeführt.

Aufgabe der Erfindung ist es daher, eine Prüfung der Leistungsendstufen vorzusehen, so dass im Falle eines Kurzschlusses die Betriebsspannung abgeschaltet bzw. gar nicht erst eingeschaltet wird und somit die Leistungsendstufe und das Bordnetz vor Schäden geschützt werden.

Diese Aufgabe wird durch das erfindungsgemäße Verfahren nach Anspruch 1 dadurch gelöst, dass von einer Steuereinrichtung folgende Schritte durchgeführt werden:
- Prüfung, ob bei nicht in den leitenden Zustand gesteuerten Halbleiterschaltern die Spannung an dem Ausgang in einem vorgegebenen mittleren Toleranzbereich liegt,
- Prüfung, ob bei in den leitenden Zustand geschaltetem oberen Halbleiterschalter die Spannung am Ausgang in einem vorgegebenen oberen Toleranzbereich liegt,
- Prüfung, ob bei in den leitenden Zustand geschaltetem unteren Halbleiterschalter die Spannung am Ausgang in einem vorgegebenen unteren Toleranzbereich liegt,
und dass die Leistungsendstufe als fehlerfrei erkannt wird, wenn alle Ausgangsspannungen innerhalb des jeweiligen Toleranzbereichs liegen.

Vorzugsweise ist bei einer vorteilhaften Ausgestaltung vorgesehen, dass vor und während der Prüfungen die Betriebsspannung über eine strombegrenzende Einrichtung zugeführt wird, und dass nach Erkennen der Leistungsendstufe als fehlerfrei die Betriebsspannung ohne Strombegrenzung zugeführt wird.

Eine andere vorteilhafte Ausgestaltung besteht darin, dass während der Prüfung die Halbleiterschalter derart kurzzeitig in den leitenden Zustand geschaltet werden, dass sowohl keine Schäden auftreten als auch der Verbraucher während der Prüfung nicht oder nur unmerklich beeinflusst wird, und dass nach Erkennen der Leistungsendstufe als fehlerfrei den Halbleiterschaltern die für den normalen Betrieb vorgesehenen Ansteuerimpulse zugeführt werden. Bei den gebräuchlichen Halbleiterschaltern kann eine Einschaltzeit von kleiner als etwa 1 bis 2 ms zweckmäßig sein.

Zur Durchführung des erfindungsgemäßen Verfahrens sind nur wenige zusätzliche Widerstände und Eingänge von an den Steuereinrichtungen ohnehin vorhandenen Analog/Digital-Wandlern erforderlich. Diese stellen zusammen mit einem geeigneten Programm in der Steuereinrichtung Fensterkomparatoren dar, die auch in anderer Weise realisiert werden können.

Mit dem erfindungsgemäßen Verfahren kann der Zustand der Leistungsendstufe differenziert beurteilt werden, wobei der jeweilige Verbraucher, beispielsweise ein Motor, während der Prüfung nicht oder nur unmerklich beeinflusst wird. Die Prüfung kann automatisch vor dem jeweiligen Einschalten der Leistungsendstufe erfolgen, beispielsweise bei der Betätigung des Zündschlüssels eines Kraftfahrzeugs, oder auch während des Betriebs durchgeführt werden.

Das erfindungsgemäße Verfahren kann an Leistungsendstufen mit einer oder mehreren Halbbrücken durchgeführt werden. Bei einem Verfahren, bei dem die Leistungsendstufe mindestens zwei Halbbrücken aufweist, ist vorgesehen, dass die Prüfungen, bei welchen die oberen bzw. die unteren Halbleiterschalter in den leitenden Zustand geschaltet werden, jeweils nacheinander für die Halbleiterschalter der einzelnen Halbbrücken durchgeführt werden. Mit diesem Verfahren ist es auch möglich, dass durch Auswertung der Ausgangsspannungen bei der Prüfung der verschiedenen Halbbrücken Leitungsunterbrechungen zwischen den Ausgängen und einem Verbraucher erkannt werden.

Eine erfindungsgemäße Anordnung gemäß Anspruch 5 löst die Aufgabe dadurch, dass die Ausgangsspannung der mindestens einen Halbbrücke und die Betriebsspannung Eingängen von Fensterkomparatoren zuführbar sind, die mit einer Steuereinrichtung verbunden sind, die eine Ansteuerschaltung für die Halbleiterschalter steuert, und dass die Steuereinrichtung mit einem Programm für folgende Schritte versehen ist:
- Prüfung, ob bei nicht in den leitenden Zustand gesteuerten Halbleiterschaltern die Spannung an dem Ausgang in einem vorgegebenen mittleren Toleranzbereich liegt,
- Prüfung, ob bei in den leitenden Zustand geschaltetem oberen Halbleiterschalter die Spannung am Ausgang in einem vorgegebenen oberen Toleranzbereich liegt,
- Prüfung, ob bei in den leitenden Zustand geschaltetem unteren Halbleiterschalter die Spannung am Ausgang in einem vorgegebenen unteren Toleranzbereich liegt,
und dass die Leistungsendstufe als fehlerfrei erkannt wird, wenn alle Ausgangsspannungen innerhalb des jeweiligen Toleranzbereichs liegen.

Eine Weiterbildung der erfindungsgemäßen Anordnung besteht darin, dass die Fensterkomparatoren von Analog/Digital-Wandlern gebildet werden, deren Ausgangswerte in der Steuereinrichtung mit den Toleranzbereichen verglichen werden.

Da die Betriebsspannung der Leistungsendstufen in der Regel wesentlich höher als diejenige von Mikroprozessoren oder digitalen Signalprozessoren ist, sind bei einer vorteilhaften Ausgestaltung der erfindungsgemäßen Anordnung die Verbindungen des Ausgangs der mindestens einen Halbbrücke und der Betriebsspannung mit den Eingängen der Fensterkomparatoren über Spannungsteiler vorgesehen.

Um bei abgeschalteten Halbleiterschaltern eine reproduzierbare Spannung am Ausgang sicherzustellen, sind bei der erfindungsgemäßen Anordnung Mittel vorgesehen, welche bewirken, dass bei nicht leitenden Halbleiterschaltern die jeweilige Ausgangsspannung in dem vorgegebenen mittleren Toleranzbereich liegt. Diese Weiterbildung ist derart ausgestaltet, dass die Mittel von einem Widerstand gebildet sind, der zwischen dem Ausgang und der Betriebsspannungsquelle liegt und zusammen mit dem Spannungsteiler am Ausgang eine Spannung im mittleren Toleranzbereich erzeugt.

Bei dieser Ausgestaltung können mindestens zwei Halbbrücken vorgesehen sein, von denen nur eine oder mehrere über Mittel verfügen, welche bewirken, dass bei nicht leitenden Halbleiterschaltern die jeweilige Ausgangsspannung in dem vorgegebenen mittleren Toleranzbereich liegt.

Eine Prüfung ohne eine Überlastung der Leistungsendstufe und der Einrichtungen zur Spannungsversorgung ist bei einer Weiterbildung der erfindungsgemäßen Anordnung dadurch möglich, dass in der Zuleitung der Betriebsspannung ein steuerbarer Schalter vorgesehen ist, dem ein Widerstand parallel geschaltet ist, und dass der steuerbare Schalter von der Steuereinrichtung steuerbar ist. Alternativ kann bei der erfindungsgemäßen Anordnung vorgesehen sein, dass die zur Prüfung dienenden Impulse derart kurz sind, dass keine Überlastung der Halbleiterschalter stattfindet.

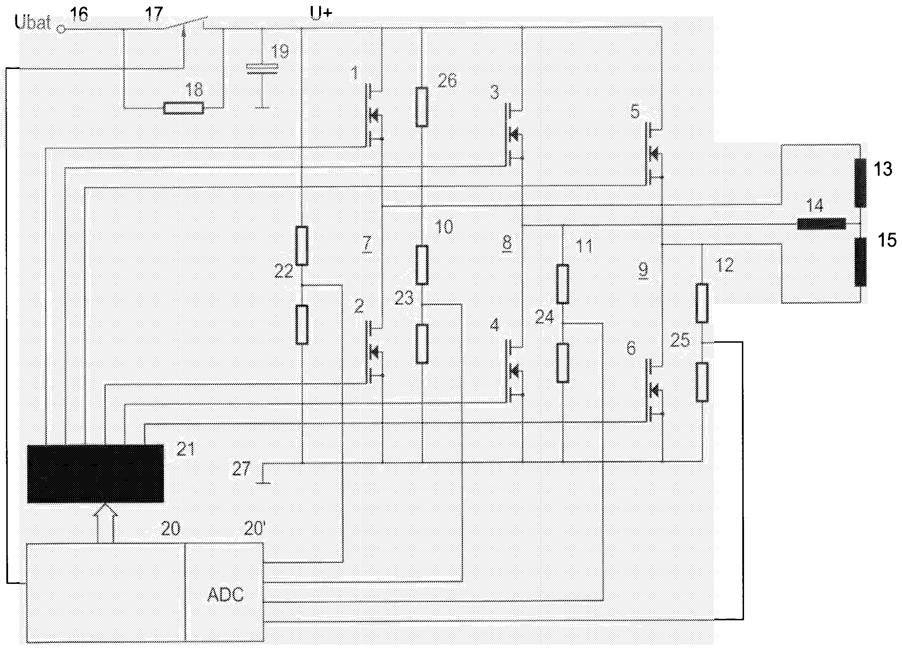

Die Erfindung lässt zahlreiche Ausführungsformen zu. Eine davon ist schematisch in der Zeichnung als Schaltbild einer erfindungsgemäßen Anordnung, bei welcher die Leistungsendstufe von drei Halbbrücken gebildet wird, dargestellt und nachfolgend beschrieben.

Bei dem dargestellten Ausführungsbeispiel bilden zwei MOSFETs 1, 2; 3, 4; 5, 6 jeweils eine Halbbrücke 7, 8, 9 mit Ausgängen 10, 11, 12, an die jeweils eine der in Sternschaltung ausgeführten Wicklungen 13, 14, 15 eines Motors angeschlossen ist. Einem Eingang 16 wird die Betriebsspannung Ubat zugeführt, die als U+ über ein Relais 17 der Leistungsendstufe zugeführt wird. Parallel zu dem Relais 17 liegt ein Strombegrenzungswiderstand 18, über den ein Elektrolyt-Kondensator 19 hoher Kapazität aufgeladen werden kann, wobei das Relais erst eingeschaltet wird, wenn die Spannung U+ etwa der Spannung Ubat entspricht. Damit wird ein unzulässig hoher Ladestromstoß vermieden. Einzelheiten zu dieser bekannten Schaltung sind in DE 100 57 156 A1 ausgeführt.

Die Anordnung umfasst ferner eine Steuereinrichtung 20, die als solche im Zusammenhang mit Leistungsendstufen bekannt ist, von einem Mikrocomputer oder einem digitalen Signalprozessor gebildet wird und als solche zum Verständnis der Erfindung nicht näher erläutert zu werden braucht. Ausgänge der Steuereinrichtung 20 sind mit einer Ansteuerschaltung 21 verbunden, welche Steuersignale HS1, HS2, HS3, LS1, LS2, LS3 für die MOSFETs 1 bis 6 erzeugt. Mit der Steuereinrichtung 20 sind ferner Analog/Digital-Wandler 20' verbunden, deren Eingängen von jeweils einem Spannungsteiler 22, 23, 24, 25 erzeugte Spannungen zuführbar sind. Die Spannungsteiler weisen wesentlich höhere Widerstandswerte als die Wicklungen 13, 14, 15 auf, um den Wirkungsgrad der Endstufe im Betrieb nicht zu verschlechtern.

Dem MOSFET 1 ist ein Widerstand 26 parallel geschaltet, der zusammen mit dem Spannungsteiler 23 bewirkt, dass am Ausgang 10 der Halbbrücke 7 im Falle von nicht leitenden MOSFETs 1, 2 die Hälfte der Spannung U+ anliegt.

Die Spannungsteiler 22 bis 25 sind derart ausgelegt, dass bei dem höchst möglichen Wert von U+ die zulässige Spannung von CMOS-Schaltungen nicht überschritten wird. Die vom Spannungsteiler 22 erzeugte Spannung dient für die folgenden beschriebenen einzelnen Prüfungen als Spannungsreferenz zur Bildung der Toleranzbereiche.

Bei der ersten Prüfung folgt keine Ansteuerung der MOSFETs 1 bis 6, so dass der Ausgang 10 die Spannung U+/2 führt, was in der Steuereinrichtung 20 unter Berücksichtigung einer vorgegebenen Toleranz überprüft wird. Ist dieses der Fall, kann daraus geschlossen werden, dass in den MOSFETs 1, 2 und in der Zuleitung zur Wicklung 13 kein Kurzschluss gegen Masse 27 oder Betriebsspannung U+ vorliegt. Bei fehlerfreier Leistungsendstufe sind bei dieser ersten Prüfung auch die MOSFETs 3 bis 6 nicht leitend, so dass über die Wicklungen 13 bis 15 des Motors die Spannungen an den Ausgängen 11, 12 ebenfalls in dem mittleren Toleranzbereich liegen, was von der Steuereinrichtung 20 geprüft wird.

Bei einer zweiten Prüfung werden nacheinander die "oberen" MOSFETs 1, 3, 5 in den leitenden Zustand geschaltet und dabei jeweils überprüft, ob die Ausgänge 10, 11, 12 eine Spannung annehmen, die in einem oberen Toleranzbereich, also in der Nähe der Spannung U+ liegt. Bei einer dritten Prüfung werden die "unteren" MOSFETs 2, 4, 6 nacheinander in den leitenden Zustand gebracht. Dabei wird jeweils überprüft, ob die Spannung an den Ausgängen 10, 11, 12 im unteren Toleranzbereich, also verglichen mit U+, in der Nähe des Massepotentials liegt. Aus der Größe der Überschreitung bzw. Unterschreitung des jeweiligen Toleranzbereichs kann auf die Art des Defekts, beispielsweise Kurzschluss oder Überlastung, geschlossen werden.

## Patentansprüche

1. Verfahren zur Prüfung einer Leistungsendstufe zum Ansteuern von elektrischen Motoren, wobei die Leistungsendstufe mindestens eine aus einer Reihenschaltung eines oberen und eines unteren Halbleiterschalters bestehende und mit Betriebsspannung beaufschlagte Halbbrücke aufweist und wobei der Verbindungspunkt der Halbleiterschalter der mindestens einen Halbbrücke einen Ausgang bildet, wobei von einer Steuereinrichtung folgende Schritte durchgeführt werden:
- Prüfung, ob bei in den leitenden Zustand geschaltetem oberen Halbleiterschalter die Spannung am Ausgang in einem vorgegebenen oberen Toleranzbereich liegt, und
- Prüfung, ob bei in den leitenden Zustand geschaltetem unteren Halbleiterschalter die Spannung am Ausgang in einem vorgegebenen unteren Toleranzbereich liegt,
**dadurch gekennzeichnet, dass** von der Steuereinrichtung ferner eine Prüfung durchgeführt wird, ob bei nicht in den leitenden Zustand gesteuerten Halbleiterschaltern die Spannung an dem Ausgang in einem vorgegebenen mittleren Toleranzbereich liegt, wobei die Leistungsendstufe als fehlerfrei erkannt wird, wenn alle Ausgangsspannungen innerhalb des jeweiligen Toleranzbereichs liegen, und wobei nach Erkennen der Leistungsendstufe als fehlerfrei den Halbleiterschaltern die für den normalen Betrieb vorgesehenen Ansteuerimpulse zugeführt werden.

2. Verfahren nach Anspruch 1, **dadurch gekennzeichnet, dass** während der Prüfung die Halbleiterschalter für eine Einschaltzeit von weniger als 2 ms in den leitenden Zustand geschaltet werden.

3. Verfahren nach einem der vorhergehenden Ansprüche, wobei die Leistungsendstufe mindestens zwei Halbbrücken aufweist, **dadurch gekennzeichnet, dass** die Prüfungen, bei welchen die oberen bzw. die unteren Halbleiterschalter in den leitenden Zustand geschaltet werden, jeweils nacheinander für die Halbleiterschalter der einzelnen Halbbrücken durchgeführt werden.

4. Anordnung zur Prüfung mit einer Leistungsendstufe zum Ansteuern von elektrischen Motoren und mit einer Steuereinrichtung, wobei die Leistungsendstufe mindestens eine aus einer Reihenschaltung eines oberen und eines unteren Halbleiterschalters bestehende und mit Betriebsspannung beaufschlagte Halbbrücke aufweist und wobei der Verbindungspunkt der Halbleiterschalter der mindestens einen Halbbrücke einen Ausgang bildet, wobei die Ausgangsspannung der mindestens einen Halbbrücke (7, 8, 9) und die Betriebsspannung Eingängen von Fensterkomparatoren (20') zuführbar sind, die mit der Steuereinrichtung (20) verbunden sind, die eine Ansteuerschaltung (21) der Anordnung für die Halbleiterschalter (1, 2, 3, 4, 5, 6) steuert, und wobei die Steuereinrichtung (20) mit einem Programm für folgende Schritte versehen ist:
- Prüfung, ob bei in den leitenden Zustand geschaltetem oberen Halbleiterschalter (1, 3, 5) die Spannung am Ausgang (10, 11, 12) in einem vorgegebenen oberen Toleranzbereich liegt,
- Prüfung, ob bei in den leitenden Zustand geschaltetem unteren Halbleiterschalter (2, 4, 6) die Spannung am Ausgang (10, 11, 12) in einem vorgegebenen unteren Toleranzbereich liegt,
und, **dadurch gekennzeichnet, dass** die Anordnung einen Widerstand (26) aufweist, der zwischen dem Ausgang (10) und der Betriebsspannungsquelle liegt und zusammen mit einem Spannungsteiler (23) am Ausgang (10) eine Spannung im mittleren Toleranzbereich erzeugt, so dass bei nicht leitenden Halbleiterschaltern die jeweilige Ausgangsspannung in dem vorgegebenen mittleren Toleranzbereich liegt, wobei das Programm ferner zur Prüfung, ob bei nicht in den leitenden Zustand gesteuerten Halbleiterschaltern (1, 2, 3, 4, 5, 6) die Spannung an dem Ausgang (10, 11, 12) in einem vorgegebenen mittleren Toleranzbereich liegt, ausgebildet ist, wobei in dem Programm die Leistungsendstufe als fehlerfrei erkannt wird, wenn alle Ausgangsspannungen innerhalb des jeweiligen Toleranzbereichs liegen, wobei nach Erkennen der Leistungsendstufe als fehlerfrei den Halbleiterschaltern die für den normalen Betrieb vorgesehenen Ansteuerimpulse zugeführt werden.

5. Anordnung nach Anspruch 4, **dadurch gekennzeichnet, dass** die Fensterkomparatoren von Analog/Digital-Wandlern (20') gebildet werden, deren Ausgangswerte in der Steuereinrichtung (20) mit den Toleranzbereichen verglichen werden.

6. Anordnung nach einem der Ansprüche 4 oder 5, **dadurch gekennzeichnet, dass** die Verbindungen des Ausgangs (10, 11, 12) der mindestens einen Halbbrücke (7, 8, 9) und der Betriebsspannung mit den Eingängen der Fensterkomparatoren (20') über Spannungsteiler (22, 23, 24, 25) vorgesehen sind.

7. Anordnung nach einem der Ansprüche Anspruch 4 bis 6, **dadurch gekennzeichnet, dass** mindestens zwei Halbbrücken (7, 8, 9) vorgesehen sind, von denen nur eine mit Mitteln (26) versehen ist, welche bewirken, dass bei nicht leitenden Halbleiterschaltern die jeweilige Ausgangsspannung in dem vorgegebenen mittleren Toleranzbereich liegt.

8. Anordnung nach einem der Ansprüche 4 bis 7, **dadurch gekennzeichnet, dass** mindestens zwei Halbbrücken (7, 8, 9) vorgesehen sind, die jeweils über Mittel verfügen, welche bewirken, dass bei nicht leitenden Halbleiterschaltern die jeweilige Ausgangsspannung in dem vorgegebenen mittleren Toleranzbereich liegt.

9. Anordnung nach einem der Ansprüche 4 bis 8, **dadurch gekennzeichnet, dass** in der Zuleitung der Betriebsspannung ein steuerbarer Schalter (17) vorgesehen ist, dem ein Widerstand (18) parallel geschaltet ist, und dass der steuerbare Schalter (17) von der Steuereinrichtung (20) steuerbar ist.

## Claims

1. Method for testing a power output stage for driving electric motors, wherein the power output stage has at least one half-bridge which consists of a series connection of an upper and a lower semiconductor switch and to which operating voltage is applied, and wherein the junction point between the semiconductor switches of the at least one half-bridge forms an output, wherein the following steps are carried out by a control device:
- performing a test to determine whether, with the upper semiconductor switch having been switched into the on state, the voltage at the output is in a predefined upper tolerance range,
- performing a test to determine whether, with the lower semiconductor switch having been switched into the on state, the voltage at the output is in a predefined lower tolerance range,
**characterized in that** the control device furthermore carries out a test to determine whether, with the semiconductor switches not having been controlled into the on state, the voltage at the output is in a predefined middle tolerance range, wherein the power output stage is identified as free of defects if all the output voltages are within the respective tolerance range, and wherein the drive pulses provided for normal operation are fed to the semiconductor switches after the power output stage has been identified as free of defects.

2. Method according to Claim 1, **characterized in that** during the test the semiconductor switches are switched into the on state for a switch-on time of less than 2 ms.

3. Method according to either of the preceding claims, wherein the power output stage has at least two half-bridges, **characterized in that** the tests during which the upper and respectively the lower semiconductor switches are switched into the on state are carried out in each case successively for the semiconductor switches of the individual half-bridges.

4. Arrangement for testing comprising a power output stage for driving electric motors and comprising a control device, wherein the power output stage has at least one half-bridge which consists of a series connection of an upper and a lower semiconductor switch and to which operating voltage is applied and wherein the junction point between the semiconductor switches of the at least one half-bridge forms an output, wherein the output voltage of the at least one half-bridge (7, 8, 9) and the operating voltage are able to be fed to inputs of window comparators (20') connected to the control device (20), which controls a drive circuit (21) of the arrangement for the semiconductor switches (1, 2, 3, 4, 5, 6) and wherein the control device (20) is provided with a programme for the following steps:
- performing a test to determine whether, with the upper semiconductor switch (1, 3, 5) having been switched into the on state, the voltage at the output (10, 11, 12) is in a predefined upper tolerance range,
- performing a test to determine whether, with the lower semiconductor switch (2, 4, 6) having been switched into the on state, the voltage at the output (10, 11, 12) is in a predefined lower tolerance range,
and **characterized in that** the arrangement has a resistor (26), which is connected between the output (10) and the operating voltage source and, together with a voltage divider (23), generates a voltage in the middle tolerance range at the output (10), such that, with the semiconductor switches not in the on state, the respective output voltage is in the predefined middle tolerance range, wherein the programme is further configured for performing a test to determine whether, with the semiconductor switches (1, 2, 3, 4, 5, 6) not having been controlled into the on state, the voltage at the output (10, 11, 12) is in a predefined middle tolerance range, wherein in the programme the power output stage is identified as free of defects if all the output voltages are within the respective tolerance range, wherein the drive pulses provided for normal operation are fed to the semiconductor switches after the power output stage has been identified as free of defects.

5. Arrangement according to Claim 4, **characterized in that** the window comparators are formed by analogue/digital converters (20'), the output values of which are compared with the tolerance ranges in the control device (20).

6. Arrangement according to either of Claims 4 and 5, **characterized in that** the connections of the output (10, 11, 12) of the at least one half-bridge (7, 8, 9) and of the operating voltage to the inputs of the window comparators (20') are provided by way of voltage dividers (22, 23, 24, 25).

7. Arrangement according to any of Claims 4 to 6, **characterized in that** at least two half-bridges (7, 8, 9) are provided, only one of which is provided with means (26) which have the effect that, with the semiconductor switches not being in the on state, the respective output voltage is in the predefined middle tolerance range.

8. Arrangement according to any of Claims 4 to 7, **characterized in that** at least two half-bridges (7, 8, 9) are provided, each of which has means which have the effect that, with the semiconductor switches not being in the on state, the respective output voltage is in the predefined middle tolerance range.

9. Arrangement according to any of Claims 4 to 8, **characterized in that** a controllable switch (17) is provided in the supply line for the operating voltage, a resistor (18) being connected in parallel with said controllable switch, and **in that** the controllable switch (17) is controllable by the control device (20) .

## Revendications

1. Procédé permettant de vérifier un étage de sortie de puissance pour piloter des moteurs électriques, dans lequel l'étage de sortie de puissance présente au moins un demi-pont composé d'un montage en série d'un commutateur semi-conducteur supérieur et d'un commutateur semi-conducteur inférieur et sollicité par une tension de fonctionnement, et dans lequel la jonction des commutateurs semi-conducteurs du au moins un demi-pont forme une sortie, un dispositif de commande effectuant les étapes suivantes consistant à :
- vérifier si la tension à la sortie se trouve dans une plage de tolérance supérieure spécifiée lorsque le commutateur semi-conducteur supérieur est commuté à l'état conducteur, et
- vérifier si la tension à la sortie se trouve dans une plage de tolérance inférieure spécifiée lorsque le commutateur semi-conducteur inférieur est commuté à l'état conducteur,
**caractérisé en ce que** le dispositif de commande procède en outre à une vérification si la tension à la sortie se trouve dans une plage de tolérance intermédiaire spécifiée lorsque les commutateurs semi-conducteurs ne sont pas commutés à l'état conducteur, dans lequel l'étage de sortie de puissance est reconnu comme étant exempt d'erreurs si toutes les tensions de sortie se trouvent à l'intérieur de la plage de tolérance respective, et dans lequel, après que l'étage de sortie de puissance a été reconnu comme étant exempt d'erreurs, les commutateurs semi-conducteurs reçoivent les impulsions de pilotage prévues pour le fonctionnement normal.

2. Procédé selon la revendication 1, **caractérisé en ce que** pendant la vérification, les commutateurs semi-conducteurs sont commutés à l'état conducteur pendant une durée de fonctionnement inférieure à 2 ms.

3. Procédé selon l'une quelconque des revendications précédentes, dans lequel l'étage de sortie de puissance présente au moins deux demi-ponts, **caractérisé en ce que** les vérifications, pendant lesquelles les commutateurs semi-conducteurs supérieurs ou inférieurs sont commutés à l'état conducteur, sont effectuées respectivement les unes après les autres pour les commutateurs semi-conducteurs des demi-ponts individuels.

4. Ensemble de vérification, comprenant un étage de sortie de puissance pour piloter des moteurs électriques, et comprenant un dispositif de commande, dans lequel l'étage de sortie de puissance présente au moins un demi-pont composé d'un montage en série d'un commutateur semi-conducteur supérieur et d'un commutateur semi-conducteur inférieur et sollicité par une tension de fonctionnement, et dans lequel la jonction des commutateurs semi-conducteurs du au moins un demi-pont forme une sortie, dans lequel la tension de sortie du au moins un demi-pont (7, 8, 9) et la tension de fonctionnement peuvent être amenées à des entrées de comparateurs à fenêtre (20') reliés au dispositif de commande (20) qui commande un circuit de pilotage (21) de l'ensemble pour les commutateurs semi-conducteurs (1, 2, 3, 4, 5, 6), et le dispositif de commande (20) étant muni d'un programme pour les étapes suivantes consistant à :
- vérifier si la tension à la sortie (10, 11, 12) se trouve dans une plage de tolérance supérieure spécifiée lorsque le commutateur semi-conducteur supérieur (1, 3, 5) est commuté à l'état conducteur,
- vérifier si la tension à la sortie (10, 11, 12) se trouve dans une plage de tolérance inférieure spécifiée lorsque le commutateur semi-conducteur inférieur (2, 4, 6) est commuté à l'état conducteur, et
**caractérisé en ce que** l'ensemble présente une résistance (26) qui est située entre la sortie (10) et la source de tension de fonctionnement et génère avec un diviseur de tension (23) à la sortie (10) une tension dans la plage de tolérance intermédiaire de sorte que lorsque les commutateurs semi-conducteurs ne sont pas conducteurs, la tension de sortie respective se trouve dans la plage de tolérance intermédiaire spécifiée, dans lequel le programme est en outre réalisé pour vérifier si la tension à la sortie (10, 11, 12) se trouve dans une plage de tolérance intermédiaire spécifiée lorsque les commutateurs semi-conducteurs (1, 2, 3, 4, 5, 6) ne sont pas commandés à l'état conducteur, dans lequel l'étage de sortie de puissance est reconnu dans le programme comme étant exempt d'erreurs si toutes les tensions de sortie se trouvent à l'intérieur de la plage de tolérance respective, dans lequel, après que l'étage de sortie de puissance a été reconnu comme étant exempt d'erreurs, les impulsions de pilotage prévues pour le fonctionnement normal sont amenées aux commutateurs semi-conducteurs.

5. Ensemble selon la revendication 4, **caractérisé en ce que** les comparateurs à fenêtre sont formés par des convertisseurs analogique/numérique (20') dont les valeurs de sortie sont comparées aux plages de tolérance dans le dispositif de commande (20).

6. Ensemble selon l'une quelconque des revendications 4 ou 5, **caractérisé en ce que** les connexions de la sortie (10, 11, 12) du au moins un demi-pont (7, 8, 9) et de la tension de fonctionnement aux entrées des comparateurs à fenêtre (20') sont prévues en passant par des diviseurs de tension (22, 23, 24, 25).

7. Ensemble selon l'une quelconque des revendications 4 à 6, **caractérisé en ce qu'**au moins deux demi-ponts (7, 8, 9) sont prévus dont un seul est muni de moyens (26) faisant que la tension de sortie respective se trouve dans la plage de tolérance intermédiaire spécifiée lorsque les commutateurs semi-conducteurs ne sont pas conducteurs.

8. Ensemble selon l'une quelconque des revendications 4 à 7, **caractérisé en ce qu'**au moins deux demi-ponts (7, 8, 9) sont prévus qui disposent respectivement de moyens faisant que la tension de sortie respective se trouve dans la plage de tolérance intermédiaire spécifiée lorsque les commutateurs semi-conducteurs ne sont pas conducteurs.

9. Ensemble selon l'une quelconque des revendications 4 à 8, **caractérisé en ce qu'**un commutateur réglable (17) est prévu sur le câble d'alimentation de la tension de fonctionnement avec lequel une résistance (18) est connectée en parallèle, et **en ce que** le commutateur réglable (17) peut être réglé par le dispositif de commande (20).
